(19) 

Europäisches Patentamt

European Patent Office

Office européen des brevets

(11) **EP 4 730 163 A1**

(12) **EUROPEAN PATENT APPLICATION**
published in accordance with Art. 153(4) EPC

(43) Date of publication:
**22.04.2026 Bulletin 2026/17**

(21) Application number: **25814550.7**

(22) Date of filing: **28.04.2025**

(51) International Patent Classification (IPC):
**G06F 18/213** (2023.01)    **G01R 31/367** (2019.01)

(52) Cooperative Patent Classification (CPC):
**Y02E 60/10**

(86) International application number:
**PCT/CN2025/091759**

(87) International publication number:
**WO 2025/246772 (04.12.2025 Gazette 2025/49)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH LA MA MD TN**

(30) Priority: **27.05.2024 CN 202410657865**

(71) Applicant: **IBATTERYCLOUD CO., LTD.
Yantai, Shandong 264000 (CN)**

(72) Inventors:
• **CI, Song
Yantai, Shandong 264004 (CN)**
• **ZHANG, Ming
Yantai, Shandong 264004 (CN)**

• **LI, Chaofan
Yantai, Shandong 264004 (CN)**
• **LI, Kai
Yantai, Shandong 264004 (CN)**
• **LI, Xuefeng
Yantai, Shandong 264004 (CN)**
• **BAI, Xuheng
Yantai, Shandong 264004 (CN)**
• **WANG, Yunfang
Yantai, Shandong 264004 (CN)**
• **LIU, Zhiquan
Yantai, Shandong 264004 (CN)**

(74) Representative: **Chung, Hoi Kan
Mandarin IP Limited
7 Cherry Trees
Great Shelford
Cambridge CB22 5XA (GB)**

(54) **LITHIUM BATTERY OPERATING DATA FEATURE MAP EXTRACTION METHOD, AND APPARATUS, MEDIUM AND PRODUCT**

(57)    Disclosed are a method, device, medium, and product for extracting feature maps from operational data of lithium batteries in the technical field of energy storage in renewable energy power systems. The method includes: acquiring operational data of a lithium battery in an energy storage system; selecting target operational data from the operational data using a sliding window to obtain a plurality of target data groups; sorting a plurality of operational data in each of the target data groups according to a chronological order of preset indicator time points, to obtain an initial matrix; performing mean-variance normalization processing on each column of the initial matrix, to obtain a normalized matrix; calculating a covariance matrix of the normalized matrix; performing singular value decomposition on the covariance matrix to obtain an eigenvector matrix; calculating a dimensionality reduction matrix corresponding to each of the target data groups according to the eigenvector matrix; scaling the dimensionality reduction matrix to construct a three-dimensional feature map matrix; and converting the three-dimensional feature map matrix into an image, to obtain a feature image of the lithium battery. This disclosure can improve the comprehensiveness, versatility, and robustness of feature extraction.

**EP 4 730 163 A1**

**(Cont. next page)**

S1 — Acquire operational data of a lithium battery in an energy storage system

S2 — Select target operational data from the operational data using a sliding window according to a preset size and a preset data interval of the sliding window, to obtain a plurality of target data groups

S3 — Sort a plurality of operational data in each of the target data groups according to a chronological order of preset indicator time points, to obtain an initial matrix corresponding to each of the target data groups

S4 — Perform mean-variance normalization processing on each column of the initial matrix to obtain a normalized matrix corresponding to each of the target data groups

S5 — Calculate a covariance matrix of the normalized matrix

S6 — Perform singular value decomposition on the covariance matrix to obtain an eigenvector matrix corresponding to each of the target data groups

S7 — Calculate a dimensionality reduction matrix corresponding to each of the target data groups according to the eigenvector matrix

S8 — Scale the dimensionality reduction matrix to construct a three-dimensional feature map matrix corresponding to each of the target data groups

S9 — Convert the three-dimensional feature map matrix into an image to obtain a feature image of the lithium battery

FIG. 1

**Description**

TECHNICAL FIELD

This disclosure relates to the technical field of energy storage in renewable energy power systems and, in particular, to a method, device, medium, and product for extracting feature maps from operational data of lithium batteries.

BACKGROUND

With the continuous expansion of renewable energy power generation installation scale, the proportion of renewable energy power generation in the power grid is increasing. However, due to the small unit capacity, large quantity, dispersed distribution, and significant intermittency, volatility, and randomness of renewable energy power generation, a high proportion of renewable energy grid integration is bound to bring unprecedented challenges to the power system's supply-demand balance, security, stability control, and other aspects. Energy storage systems are a critical link in regulating the supply-demand imbalance between renewable energy power generation and the power system, as well as in energy management and optimization. The core of energy storage systems consists of a large number of lithium-ion batteries connected in series and parallel structures. Lithium batteries charge and discharge through internal electrochemical reactions. Due to the complexity of internal electrochemical reactions and the instability of environmental conditions, directly characterizing the internal state changes of batteries is highly difficult. Currently, the common approach involves collecting operational data of a lithium battery, extracting key data features, and then mining and analyzing feature data to evaluate an operational state of the lithium battery.

Conventional methods for extracting features from operational data of a lithium battery mainly suffer from the following drawbacks: 1. incomprehensive feature characterization: conventional feature extraction methods can only partially characterize data features in the time domain and indicator dimensions, failing to fully represent the battery's operational state; 2. poor versatility: most conventional feature extraction methods are designed for specific battery types or application scenarios, lacking versatility; 3. inferior robustness: conventional feature extraction methods are often sensitive to noise and abnormal data, resulting in inferior robustness; and 4. low efficiency in adapting to downstream algorithms: due to the large scale of operational data of a lithium battery and the complexity of downstream algorithms, conventional feature extraction methods often fail to meet the efficiency requirements of downstream data analysis algorithms.

SUMMARY

This disclosure is intended to provide a method, device, medium, and product for extracting feature maps from operational data of lithium batteries, which can improve the comprehensiveness, versatility, and robustness of feature extraction.

To achieve the aforementioned objectives, this disclosure provides the following solutions:

a method for extracting feature maps from operational data of lithium batteries, including the following steps:

acquiring operational data of a lithium battery in an energy storage system, where the operational data includes voltage, current, temperature, and charge-discharge capacity corresponding to each preset indicator time point;

selecting target operational data from the operational data using a sliding window according to a preset size and a preset data interval of the sliding window, to obtain a plurality of target data groups;

sorting a plurality of operational data in each of the target data groups according to a chronological order of the preset indicator time points, to obtain an initial matrix corresponding to each of the target data groups, where a row vector of the initial matrix is the operational data; and a column vector of the initial matrix includes a voltage column vector corresponding to the voltage, a current column vector corresponding to the current, a temperature column vector corresponding to the temperature, and a charge-discharge capacity column vector corresponding to the charge-discharge capacity;

performing mean-variance normalization processing on each column of the initial matrix, to obtain a normalized matrix corresponding to each of the target data groups;

calculating a covariance matrix of the normalized matrix;

performing singular value decomposition on the covariance matrix, to obtain an eigenvector matrix corresponding to each of the target data groups;

calculating a dimensionality reduction matrix corresponding to each of the target data groups according to the eigenvector matrix;

scaling the dimensionality reduction matrix to construct a three-dimensional feature map matrix corresponding to each of the target data groups; and

converting the three-dimensional feature map matrix into an image, to obtain a feature image of the lithium battery.

Optionally, the method further includes:
when a null value exists in the initial matrix, applying a linear interpolation algorithm to determine a numerical value of the null value.

Optionally, the step of calculating the dimensionality reduction matrix corresponding to each of the target data groups according to the eigenvector matrix specifically includes:

arranging each eigenvector of the eigenvector matrix by column in descending order according to corresponding eigenvalues, to obtain an updated eigenvector matrix; and
calculating the dimensionality reduction matrix according to the updated eigenvector matrix.

Optionally, the step of scaling the dimensionality reduction matrix to construct a three-dimensional feature map matrix corresponding to each of the target data groups specifically includes:

scaling the dimensionality reduction matrix by column, to obtain scaled numerical values of elements in each column;
obtaining a scaled matrix according to the scaled numerical values of the elements in each column; and
determining the three-dimensional feature map matrix from the scaled matrix according to a preset feature map length.

Optionally, the step of converting the three-dimensional feature map matrix into the image, to obtain the feature image of the lithium battery, specifically includes:

converting the three-dimensional feature map matrix into an image according to an RGB rule, to obtain a feature image corresponding to each of the target data groups; and
determining the feature image corresponding to the operational data of the lithium battery according to the feature image corresponding to each of the target data groups.

A computer device, including: a memory, a processor, and a computer program stored on the memory and executable on the processor, where the processor executes the computer program to implement the method for extracting the feature maps from the operational data of the lithium batteries of any one of the foregoing.

A computer-readable storage medium having a computer program stored thereon, where the computer program, when executed by a processor, implements the method for extracting the feature maps from the operational data of the lithium batteries of any one of the foregoing.

A computer program product, including a computer program, where the computer program, when executed by a processor, implements the method for extracting the feature maps from the operational data of the lithium batteries of any one of the foregoing.

According to the embodiments provided by this disclosure, the following technical effects are disclosed:
this disclosure improves the comprehensiveness of feature extraction from operational data of lithium batteries through a feature map extraction method, enhances the versatility and robustness of feature extraction from operational data of lithium batteries through data processing and data standardization methods, and increases the execution efficiency of downstream algorithms through feature dimensionality reduction.

BRIEF DESCRIPTION OF THE DRAWINGS

To describe the technical solutions in the embodiments of this disclosure or in the prior art more clearly, the following will briefly introduce the accompanying drawings required for describing the embodiments. Apparently, the accompanying drawings in the following description show merely some embodiments of this disclosure, and a person of ordinary skill in the art may still derive other drawings from these accompanying drawings without creative efforts.

FIG. 1 shows a schematic flowchart of a method for extracting feature maps from operational data of lithium batteries according to Example 1 of this disclosure;
FIG. 2 shows a visualization curve of various indicator data of battery operation in a time direction according to this disclosure;
FIG. 3 shows a first effect diagram of applying this disclosure to extract a feature map from various indicator data of battery operation;
FIG. 4 shows a second effect diagram of applying this disclosure to extract a feature map from various indicator data of battery operation; and

FIG. 5 shows an internal structure of a computer device.

DETAILED DESCRIPTION OF THE EMBODIMENTS

The technical solutions in the embodiments of this disclosure will be clearly and completely described below with reference to the accompanying drawings in the embodiments of this disclosure. Apparently, the described embodiments are merely some rather than all of the embodiments of this disclosure. All other embodiments obtained by a person of ordinary skill in the art based on the embodiments of this disclosure without making creative efforts shall fall within the protection scope of this disclosure.

This disclosure is intended to provide a method, device, medium, and product for extracting feature maps from operational data of lithium batteries, aiming to improve the comprehensiveness, versatility, and robustness of feature extraction.

To make the aforementioned objectives, features, and advantages of this disclosure more comprehensible, a detailed explanation of this disclosure will be given below with reference to the accompanying drawings and specific implementation manners.

Example 1

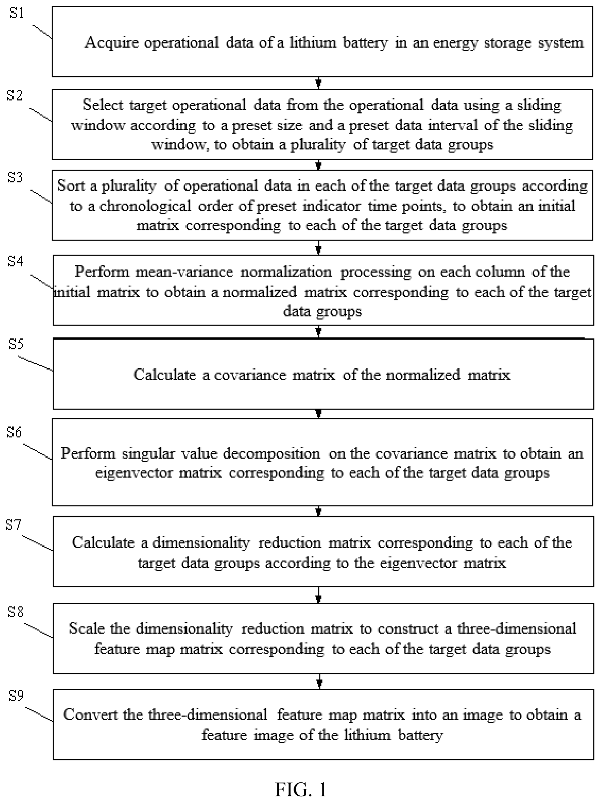

As shown in FIG. 1, this example provides a method for extracting feature maps from operational data of lithium batteries, including:

S1: acquiring operational data of a lithium battery in an energy storage system, where the operational data includes voltage, current, temperature, and charge-discharge capacity corresponding to each preset indicator time point.

S2: selecting target operational data from the operational data using a sliding window according to a preset size and a preset data interval of the sliding window, to obtain a plurality of target data groups.

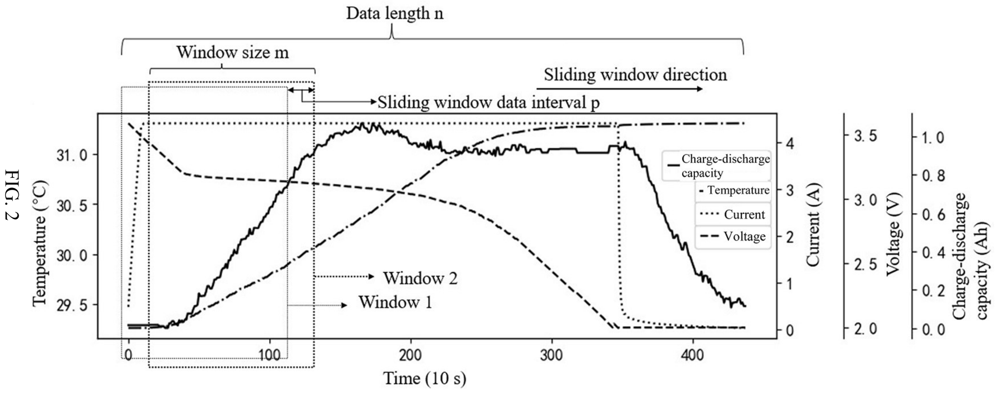

In practical applications, as shown in FIG. 2, the inputs include: a feature map length m, a sliding window data interval p, and operational data of a battery containing indicator time, voltage, current, temperature, and charge-discharge capacity, with a data length of n. The sliding window data interval refers to a step size, and the window size is the feature map length m.

S3: sorting a plurality of operational data in each of the target data groups according to a chronological order of the preset indicator time points, to obtain an initial matrix corresponding to each of the target data groups, where a row vector of the initial matrix is the operational data; and a column vector of the initial matrix includes a voltage column vector corresponding to the voltage, a current column vector corresponding to the current, a temperature column vector corresponding to the temperature, and a charge-discharge capacity column vector corresponding to the charge-discharge capacity.

In a specific implementation manner, the method further includes:
when a null value exists in the initial matrix, applying a linear interpolation algorithm to determine a numerical value of the null value.

In practical applications, the input data is arranged by the time column in ascending order, and linear interpolation is performed for null value positions, as shown below:

$$\cdots$$
$$\begin{pmatrix} D_{k-1} & V_{k-1} & I_{k-1} & T_{k-1} & Q_{k-1} \\ D_{k} & V_{k} & \text{nan} & T_{k} & Q_{k} \\ D_{k+1} & V_{k+1} & I_{k+1} & T_{k+1} & Q_{k+1} \end{pmatrix} \rightarrow$$
$$\cdots$$

$$\cdots$$
$$\begin{pmatrix} D_{k-1} & V_{k-1} & I_{k-1} & T_{k-1} & Q_{k-1} \\ D_{k} & V_{k} & I_{k-1} + \frac{D_{k}-D_{k-1}}{D_{k+1}-D_{k-1}} \cdot \frac{I_{k}-I_{k-1}}{I_{k+1}-I_{k-1}} & T_{k} & Q_{k} \\ D_{k+1} & V_{k+1} & I_{k+1} & T_{k+1} & Q_{k+1} \end{pmatrix};$$
$$\cdots$$

where the subscripts k-1, k, and k+1 respectively represent the row indices of the initial matrix; $D_{k}$, $V_{k}$, $I_{k}$, $T_{k}$, and $Q_{k}$ represent the time, voltage, current, temperature, and charge-discharge capacity of a kth row after sorting, respectively; $D_{k-1}$, $V_{k-1}$, $I_{k-1}$, $T_{k-1}$, and $Q_{k-1}$ represent the time, voltage, current, temperature, and charge-discharge capacity of a (k-1)th

row after sorting, respectively; $D_{k+1}$, $V_{k+1}$, $I_{k+1}$, $T_{k+1}$, and $Q_{k+1}$ represent the time, voltage, current, temperature, and charge-discharge capacity of a $(k+1)^{th}$ row after sorting, respectively; and nan represents a null value. After data processing, voltage, current, temperature, and charge-discharge capacity data are extracted to form an $n \times 4$ matrix $A = (V, I, T, Q)$, where V, I, T, and Q represent processed $n \times 1$ vectors.

S4: performing mean-variance normalization processing on each column of the initial matrix, to obtain a normalized matrix corresponding to each of the target data groups.

In practical applications, mean-variance normalization is performed on each column of the matrix A. The specific formula is as follows:

$$S = \left( \frac{A_{kj} - \frac{\sum_{k=1}^{n} A_{kj}}{n}}{\sqrt{\frac{\sum_{k=1}^{n} (A_{kj} - \frac{\sum_{k=1}^{n} A_{kj}}{n})^2}{n}}} \right);$$

where $1 \leq k \leq n$; $1 \leq j \leq 4$; and $A_{kj}$ represents an element at the $k^{th}$ row and $j^{th}$ column of the matrix A.

S5: calculating a covariance matrix of the normalized matrix.

In practical applications, a covariance matrix of the matrix S is calculated:

$$W = \frac{1}{n} \sum_{k=1}^{n} (s_k - \bar{s})(s_k - \bar{s})^T;$$

where $s_k$ is a $1 \times 4$ row vector representing a $k^{th}$ row of the matrix S; $\bar{s}$ is a $1 \times 4$ row vector representing a mean vector of the matrix S in the column direction; and $(s_k - \bar{s})^T$ represents a transpose matrix of $(s_k - \bar{s})$.

S6: performing singular value decomposition on the covariance matrix, to obtain an eigenvector matrix corresponding to each of the target data groups.

In practical applications, singular value decomposition is performed on the covariance matrix W, and $W = U\Sigma V$, where U is a $4 \times 4$ left singular matrix; $\Sigma$ is a singular value matrix with singular values on the main diagonal and all other elements being 0; V is an $n \times n$ right singular matrix; and U, $\Sigma$, and V can be obtained by solving the following system of equations:

$$\begin{cases} (AA^T)u_h = \lambda_h u_h \\ (A^T A)v_g = \lambda_g v_g \end{cases};$$

where $h = 1,2,3,4$; $g = 1,2, ... n$; $\lambda_h$ and $\lambda_g$ are singular values, which correspond to the main diagonal elements of $\Sigma$; $u_h$ and $v_g$ are eigenvectors, representing the column vectors of matrices U and V, respectively; and $A^T$ represents a transpose matrix of A.

S7: calculating a dimensionality reduction matrix corresponding to each of the target data groups according to the eigenvector matrix.

The step S7 specifically includes:

S71: arranging each eigenvector of the eigenvector matrix by column in descending order according to corresponding eigenvalues, to obtain an updated eigenvector matrix.

S72: calculating the dimensionality reduction matrix according to the updated eigenvector matrix.

In practical applications, eigenvectors are arranged by column in descending order from left to right according to their corresponding eigenvalues, and U, $\Sigma$, and V are updated to calculate the dimensionality reduction matrix:

$$B = U^\tau \Sigma^\tau V^\tau;$$

where $U^\tau$, $\Sigma^\tau$, and $V^\tau$ represent matrices composed of the first $\tau$ rows of U, $\Sigma$, and V; and when $\tau = 3$, B is an $n \times 3$ matrix.

Eigenvectors corresponding to larger eigenvalues contain more information from the original matrix. Arranging the eigenvalues in descending order from left to right facilitates the subsequent selection of eigenvectors based on the reduced dimensionality. There is a one-to-one correspondence between the eigenvectors and the eigenvalues; and when the eigenvalues are reordered, the eigenvectors must also be reordered according to the eigenvalue sequence.

S8: scaling the dimensionality reduction matrix to construct a three-dimensional feature map matrix corresponding to each of the target data groups.

The step S8 specifically includes:

S81: scaling the dimensionality reduction matrix by column, to obtain scaled numerical values of elements in each column.

S82: obtaining a scaled matrix according to the scaled numerical values of the elements in each column.

In practical applications, the matrix B is scaled by column to a range of [0,255], as the intensity value range of an RGB color system is [0,255], as shown below:

$$B' = \left( 255 \times \frac{B_{ij}}{\max\limits_{1 \le i \le n} B_{ij} - \min\limits_{1 \le i \le n} B_{ij}} \right)_{n \times 3};$$

where $\max\limits_{1 \le i \le n} B_{ij}$ and $\min\limits_{1 \le i \le n} B_{ij}$ represent the maximum and minimum values at an $i^{th}$ row and $j^{th}$ column of the matrix B, respectively.

S83: determining the three-dimensional feature map matrix from the scaled matrix according to a preset feature map length.

Step 7: a starting position i is selected, where $i \le n - 2(m-1)p$, and an $m \times m \times 3$ three-dimensional feature map matrix is constructed according to a feature map length m:

$$C_i = (X_i \quad Y_i \quad \dots\dots \quad Z_i);$$

where

$$X_i = \begin{pmatrix} \left( B'_{i,1}, B'_{i,2}, B'_{i,3} \right) \\ \left( B'_{i+p,1}, B'_{i+p,2}, B'_{i+p,3} \right) \\ \dots\dots \\ \left( B'_{i+(m-1)p,1}, B'_{i+(m-1)p,2}, B'_{i+(m-1)p,3} \right) \end{pmatrix};$$

$$Y_i = \begin{pmatrix} \left( B'_{i+p,1}, B'_{i+p,2}, B'_{i+1,3} \right) \\ \left( B'_{i+2p,1}, B'_{i+2p,2}, B'_{i+2p,3} \right) \\ \dots\dots \\ \left( B'_{i+mp,1}, B'_{i+mp,2}, B'_{i+mp,3} \right) \end{pmatrix};$$

$$Z_i = \begin{pmatrix} \left( B'_{i+(m-1)p,1}, B'_{i+(m-1)p,2}, B'_{i+(m-1)p,3} \right) \\ \left( B'_{i+mp,1}, B'_{i+mp,2}, B'_{i+mp,3} \right) \\ \dots\dots \\ \left( B'_{i+2(m-1)p,1}, B'_{i+2(m-1)p,2}, B'_{i+2(m-1)p,3} \right) \end{pmatrix};$$

where $B'_{i,j}$ represents an element at an $i^{th}$ row and $j^{th}$ column of the matrix B'.

where i represents the $i^{th}$ row of the matrix B' and is unrelated to the sliding window; according to the construction method of $(X_i, Y_i, Z_i)$, the subscript $i + 2(m-1)p$ in the last element $B'_{i+2(m-1)p,3}$ of the matrix must be less than or equal to n, hence $i \le n - 2(m-1)p$.

The reason for constructing an $m \times m \times n$ three-dimensional feature map matrix is that, according to the rules of an RGB image system, $m \times m$ represents the length and width of an image, namely the number of pixels. Each pixel is represented by a triplet (R, G, B), which respectively denote the intensity values of red, green, and blue colors.

S9: converting the three-dimensional feature map matrix into an image, to obtain a feature image of the lithium battery.

The step S9 specifically includes:

S91: converting the three-dimensional feature map matrix into an image according to an RGB rule, to obtain a feature image corresponding to each of the target data groups.

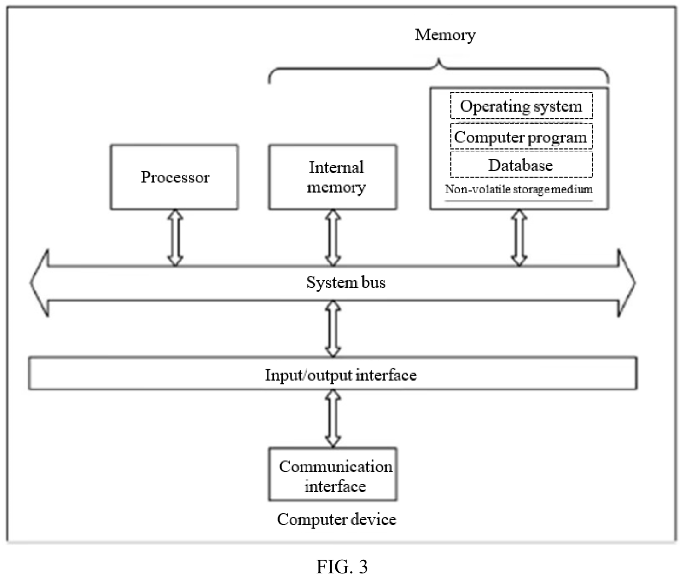

In practical applications, as shown in FIGs. 3 & 4, the feature map matrix $C_i$ is converted into an image according to RGB rules, which constitutes the feature image of the battery at the time point i.

S92: determining the feature image corresponding to the operational data of the lithium battery according to the feature image corresponding to each of the target data groups.

This disclosure has the following beneficial effects: by providing a method for extracting feature maps from operational data of lithium batteries, it addresses the issues of partial feature extraction and poor versatility in conventional battery data feature extraction methods, enhances robustness of conventional battery data feature extraction methods, and improves the execution efficiency of downstream algorithms. The use of RGB images to represent comprehensive features of operational states of batteries enhances feature interpretability while enabling better adaptation of battery data to efficient deep learning algorithms.

Example 2

A computer device, including: a memory, a processor, and a computer program stored on the memory and executable on the processor, where the processor executes the computer program to implement the method for extracting the feature maps from the operational data of the lithium batteries described in Example 1.

Example 3

A computer-readable storage medium having a computer program stored thereon, where the computer program, when executed by a processor, implements the method for extracting the feature maps from the operational data of the lithium batteries described in Example 1.

Example 4

A computer program product, including a computer program, where the computer program, when executed by a processor, implements the method for extracting the feature maps from the operational data of the lithium batteries described in Example 1.

Example 5

A computer device, which may be a database and may have an internal structure shown in FIG. 5. The computer device includes a processor, a memory, an input/output interface (I/O), and a communication interface, where the processor, memory, and input/output interface are connected via a system bus, while the communication interface is connected to the system bus through the input/output interface; the processor is configured to provide computing and control capabilities; the memory includes a non-volatile storage medium and an internal memory, where the non-volatile storage medium stores an operating system, a computer program, and a database, while the internal memory provides an environment for running the operating system and the computer program stored in the non-volatile storage medium; the database is configured to store pending transactions; the input/output interface is configured to exchange information between the processor and external devices; the communication interface is configured to communicate with external terminals via network connections; and the computer program is executed by the processor to implement the method for extracting the feature maps from the operational data of the lithium batteries described in Example 1.

It should be noted that all object-related information (including but not limited to object-related device information and object-related personal information) and data (including but not limited to data used for analysis, stored data, and displayed data) involved in this disclosure are authorized by the relevant objects or fully authorized by all concerned parties, and the collection, use, and processing of such data must comply with the relevant laws, regulations, and standards.

A person of ordinary skill in the art can understand that all or part of the processes in the above-described method embodiments can be completed by instructing relevant hardware through a computer program, where the computer program can be stored in a non-volatile computer-readable storage medium and can include the processes of the above-described method embodiments when executed. Any references to the memory, database, or other media in the embodiments provided by this disclosure may include at least one of non-volatile and volatile memories. The non-volatile memory may include a read-only memory (ROM), a magnetic tape, a floppy disk, a flash memory, an optical memory, a high-density embedded non-volatile memory, a resistive random-access memory (ReRAM), a magnetoresistive random-access memory (MRAM), a ferroelectric random-access memory (FRAM), a phase-change memory (PCM), or a graphene memory. The volatile memory may include a random-access memory (RAM) or an external cache memory, among others. By way of illustration rather than limitation, the RAM may take various forms, such as a static random-access memory (SRAM) or a dynamic random-access memory (DRAM). The database involved in the embodiments provided by this disclosure may include at least one of relational and non-relational databases. The non-relational database may include a distributed database based on a blockchain, or the like, which is not limited thereto. The processor involved in the embodiments provided by this disclosure may be a general-purpose processor, a central processing unit, a graphics processing unit, a digital signal processor, a programmable logic device, or a data processing logic device, which is not limited thereto.

The technical features of the above embodiments can be combined in any way. To simplify the description, not all possible combinations of the technical features in the above embodiments are described. However, as long as there is no contradiction in the combinations of these technical features, all possible combinations should be considered to fall within the scope of this specification.

Although the embodiments are provided to elaborate the principles and implementation manners of this disclosure, the descriptions of the aforementioned embodiments are merely intended to help understand the method and core concepts of this disclosure. Meanwhile, for a person of ordinary skill in the art, variations in specific implementation manners and application scopes may occur based on the concepts of this disclosure. In conclusion, the content of this specification should not be construed as limiting this disclosure.

**Claims**

1. A method for extracting feature maps from operational data of lithium batteries, comprising the following steps:

   acquiring operational data of a lithium battery in an energy storage system, wherein the operational data comprises voltage, current, temperature, and charge-discharge capacity corresponding to each preset indicator time point;
   selecting target operational data from the operational data using a sliding window according to a preset size and a preset data interval of the sliding window, to obtain a plurality of target data groups;
   sorting a plurality of operational data in each of the target data groups according to a chronological order of the preset indicator time points, to obtain an initial matrix corresponding to each of the target data groups, wherein a row vector of the initial matrix is the operational data; a column vector of the initial matrix comprises a voltage column vector corresponding to the voltage, a current column vector corresponding to the current, a temperature column vector corresponding to the temperature, and a charge-discharge capacity column vector corresponding to the charge-discharge capacity;
   performing mean-variance normalization processing on each column of the initial matrix, to obtain a normalized matrix corresponding to each of the target data groups;
   calculating a covariance matrix of the normalized matrix;
   performing singular value decomposition on the covariance matrix, to obtain an eigenvector matrix corresponding to each of the target data groups;
   calculating a dimensionality reduction matrix corresponding to each of the target data groups according to the eigenvector matrix;
   scaling the dimensionality reduction matrix to construct a three-dimensional feature map matrix corresponding to each of the target data groups; and
   converting the three-dimensional feature map matrix into an image, to obtain a feature image of the lithium battery.

2. The method for extracting the feature maps from the operational data of the lithium batteries of claim 1, further comprising:
   when a null value exists in the initial matrix, applying a linear interpolation algorithm to determine a numerical value of the null value.

3. The method for extracting the feature maps from the operational data of the lithium batteries of claim 1, wherein the step of calculating the dimensionality reduction matrix corresponding to each of the target data groups according to the eigenvector matrix specifically comprises:

   arranging each eigenvector of the eigenvector matrix by column in descending order according to corresponding eigenvalues, to obtain an updated eigenvector matrix; and

calculating the dimensionality reduction matrix according to the updated eigenvector matrix.

4.  The method for extracting the feature maps from the operational data of the lithium batteries of claim 1, wherein the step of scaling the dimensionality reduction matrix to construct the three-dimensional feature map matrix corresponding to each of the target data groups specifically comprises:

    scaling the dimensionality reduction matrix by column, to obtain scaled numerical values of elements in each column;
    obtaining a scaled matrix according to the scaled numerical values of the elements in each column; and
    determining the three-dimensional feature map matrix from the scaled matrix according to a preset feature map length.

5.  The method for extracting the feature maps from the operational data of the lithium batteries of claim 1, wherein the step of converting the three-dimensional feature map matrix into the image, to obtain the feature image of the lithium battery, specifically comprises:

    converting the three-dimensional feature map matrix into an image according to an RGB rule, to obtain a feature image corresponding to each of the target data groups; and
    determining the feature image corresponding to the operational data of the lithium battery according to the feature image corresponding to each of the target data groups.

6.  A computer device, comprising: a memory, a processor, and a computer program stored on the memory and executable on the processor, wherein the processor executes the computer program to implement the method for extracting the feature maps from the operational data of the lithium batteries of any one of claims 1-5.

7.  A computer-readable storage medium having a computer program stored thereon, wherein the computer program, when executed by a processor, implements the method for extracting the feature maps from the operational data of the lithium batteries of any one of claims 1-5.

8.  A computer program product, comprising a computer program, wherein the computer program, when executed by a processor, implements the method for extracting the feature maps from the operational data of the lithium batteries of any one of claims 1-5.

S1 — Acquire operational data of a lithium battery in an energy storage system

S2 — Select target operational data from the operational data using a sliding window according to a preset size and a preset data interval of the sliding window, to obtain a plurality of target data groups

S3 — Sort a plurality of operational data in each of the target data groups according to a chronological order of preset indicator time points, to obtain an initial matrix corresponding to each of the target data groups

S4 — Perform mean-variance normalization processing on each column of the initial matrix to obtain a normalized matrix corresponding to each of the target data groups

S5 — Calculate a covariance matrix of the normalized matrix

S6 — Perform singular value decomposition on the covariance matrix to obtain an eigenvector matrix corresponding to each of the target data groups

S7 — Calculate a dimensionality reduction matrix corresponding to each of the target data groups according to the eigenvector matrix

S8 — Scale the dimensionality reduction matrix to construct a three-dimensional feature map matrix corresponding to each of the target data groups

S9 — Convert the three-dimensional feature map matrix into an image to obtain a feature image of the lithium battery

FIG. 1

FIG. 2

FIG. 3

## INTERNATIONAL SEARCH REPORT

| International application No. |
|---|
| **PCT/CN2025/091759** |

| A. | CLASSIFICATION OF SUBJECT MATTER |
|---|---|

G06F18/213(2023.01)i; G01R31/367(2019.01)i

According to International Patent Classification (IPC) or to both national classification and IPC

| B. | FIELDS SEARCHED |
|---|---|

Minimum documentation searched (classification system followed by classification symbols)

IPC:G06F、G01R

Documentation searched other than minimum documentation to the extent that such documents are included in the fields searched

Electronic data base consulted during the international search (name of data base and, where practicable, search terms used)

CNTXT, CNKI, CJFD, ENTXT, ENTEXC, VEN, DWPI, CNKI, WPABS, WPABSC, IEEE: 电池, 运行数据, 运行信息, 目标数据, 电流, 电压, 温度, 充放电, 协方差, 奇异值, 特征, 矩阵, 向量, 三维特征图, 图像, battery, run data, operating data, operation information, target data, electirc current, galvanic current, voltage, temperature, charge discharge, covariance, SVD, singular value, feature, matrix, vector, three-dimensional, image;

| C. | DOCUMENTS CONSIDERED TO BE RELEVANT |
|---|---|

| Category* | Citation of document, with indication, where appropriate, of the relevant passages | Relevant to claim No. |
|---|---|---|
| PX | CN 118245781 A (YUNCHU NEW ENERGY TECHNOLOGY CO., LTD.) 25 June 2024 (2024-06-25) <br> description, paragraphs [0005]-[0013] | 1-8 |
| A | CN 117783886 A (WUHAN INSTITUTE OF MARINE ELECTRIC PROPULSION (CHINA SHIPBUILDING GROUP CORPORATION NO.712 INSTITUTE)) 29 March 2024 (2024-03-29) <br> description, paragraphs [0003]-[0017] | 1-8 |
| A | CN 110058178 A (ZHENGZHOU UNIVERSITY) 26 July 2019 (2019-07-26) <br> entire document | 1-8 |
| A | CN 116449224 A (CHINA HUANENG CLEAN ENERGY RESEARCH INSTITUTE; CHINA HUANENG NEW ENERGY CO., LTD. SHANXI BRANCH) 18 July 2023 (2023-07-18) <br> entire document | 1-8 |

| ✓ Further documents are listed in the continuation of Box C. | ✓ See patent family annex. |
|---|---|

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | "&" | document member of the same patent family |
| "P" | document published prior to the international filing date but later than the priority date claimed | | |

| Date of the actual completion of the international search | Date of mailing of the international search report |
|---|---|
| **25 June 2025** | **10 July 2025** |

| Name and mailing address of the ISA/CN | Authorized officer |
|---|---|
| **China National Intellectual Property Administration (ISA/ CN)** <br> **China No. 6, Xitucheng Road, Jimenqiao, Haidian District, Beijing 100088** | |
| | Telephone No. |

Form PCT/ISA/210 (second sheet) (July 2022)

**INTERNATIONAL SEARCH REPORT**

| International application No. |
|---|
| **PCT/CN2025/091759** |

### C.    DOCUMENTS CONSIDERED TO BE RELEVANT

| Category* | Citation of document, with indication, where appropriate, of the relevant passages | Relevant to claim No. |
|---|---|---|
| A | US 2017236000 A1 (SAMSUNG ELECTRONICS CO., LTD.; NORTHEASTERN UNIVERSITY;) 17 August 2017 (2017-08-17)<br>entire document | 1-8 |
| A | 李腾等 (LI, Teng et al.). "锂离子电池热模型研究进展 (Research Progress on Thermal Models of Lithium-Ion Batteries)"<br>*电源技术 (Chinese Journal of Power Sources)*, No. 10, 20 October 2009 (2009-10-20),<br>entire document | 1-8 |

Form PCT/ISA/210 (second sheet) (July 2022)

**INTERNATIONAL SEARCH REPORT**
**Information on patent family members**

International application No.

**PCT/CN2025/091759**

| Patent document cited in search report | | | Publication date (day/month/year) | Patent family member(s) | | | Publication date (day/month/year) |
|---|---|---|---|---|---|---|---|
| CN | 118245781 | A | 25 June 2024 | None | | | |
| CN | 117783886 | A | 29 March 2024 | None | | | |
| CN | 110058178 | A | 26 July 2019 | None | | | |
| CN | 116449224 | A | 18 July 2023 | None | | | |
| US | 2017236000 | A1 | 17 August 2017 | KR | 20170096492 | A | 24 August 2017 |
| | | | | KR | 102221118 | B1 | 26 February 2021 |
| | | | | US | 10395098 | B2 | 27 August 2019 |

Form PCT/ISA/210 (patent family annex) (July 2022)